# EUROPÄISCHE PATENTSCHRIFT

(11) **EP 4 085 501 B1**
(45) Veröffentlichungstag und Bekanntmachung des Hinweises auf die Patenterteilung: **06.12.2023**
(21) Anmeldenummer: 21711831.4
(22) Anmeldetag: 10.03.2021
(51) Int. Cl.: H02H 5/12, G01R 19/15, H02H 3/04

(54) **SICHERHEITSVORRICHTUNG FÜR ARBEITEN AN ELEKTRISCHEN ANLAGEN**
SAFETY CIRCUIT FOR WORKING ON ELECTRICAL SYSTEMS
DISPOSITIF DE SÉCURITÉ POUR TRAVAIL SUR DES SYSTÈMES ÉLECTRIQUES

(30) Priorität: 12.03.2020 AT 502102020
(43) Veröffentlichungstag der Anmeldung: 09.11.2022
(73) Patentinhaber: Adaptive Regelsysteme Gesellschaft mbH, 5020 Salzburg (AT)
(72) Erfinder: HOLZTRATTNER, Dietmar, 5440 Scheffau am Tennengebirge (AT); ALTENBUCHNER, Michael, 5020 Salzburg (AT)
(74) Vertreter: Patentanwälte Pinter & Weiss OG
(86) Internationale Anmeldenummer: PCT/EP2021/055966
(87) Internationale Veröffentlichungsnummer: WO 2021/180750

(56) Entgegenhaltungen:
- WO-A1-2019/243379
- WO-A1-2019/243388
- US-A1- 2005 101 875

## Beschreibung

Die gegenständliche Erfindung betrifft eine Sicherheitsvorrichtung mit zumindest zwei Hautelektroden, in der eine erste Messeinrichtung und eine Messsignalauswerteeinheit vorgesehen sind, wobei die erste Messeinrichtung ein erstes elektrisches Messsignal in einem Messfrequenzbereich zwischen den zumindest zwei Hautelektroden erfasst und die Messsignalauswerteeinheit aus dem erfassten ersten Messsignal ein Auswertesignal ermittelt und die Sicherheitsvorrichtung auslöst, wenn das Auswertesignal eine vorgegebene Auslöseempfindlichkeit der Sicherheitsvorrichtung erreicht, und eine Energiequelle vorgesehen ist, die über die zumindest zwei Hautelektroden ein elektrisches Einspeisesignal mit einer vorgegebenen Einspeisefrequenz ungleich dem Messfrequenzbereich eingespeist, wobei eine zweite Messeinrichtung und eine Widerstandauswerteeinheit vorgesehen sind und die zweite Messeinrichtung ein zweites elektrisches Messsignal bei der Einspeisefrequenz erfasst und die Widerstandauswerteeinheit aus dem erfassten zweiten Messsignal und dem Einspeisesignal einen zwischen den zumindest zwei Hautelektroden auftretenden Körperwiderstand ermittelt. Die Erfindung betrifft ferner ein Verfahren zum Betreiben einer solche Sicherheitsvorrichtung.

Hautelektroden werden auch für andere Zwecke eingesetzt, beispielsweise zur Ermittlung der Bio-Impedanz, wie aus der US 2005/0101875 A1 bekannt. Hierbei wird über die Elektrode ein Körperstrom eingeprägt und ein Antwortsignal ausgewertet.

Es ist üblich an elektrischen Anlagen, insbesondere im industriellen Umfeld, einen Notaus vorzusehen, um im Falle der Berührung eines unter Spannung stehenden oder stromführenden Bauteils durch eine Person den Bauteil, der im Notaus-Stromkreis ist, mit dem Notaus spannungsfrei zu schalten. Mit solchen Sicherheitsvorrichtungen kann die Sicherheit von an unter Spannung stehenden Teilen oder stromführenden Teilen arbeitenden Personen vor Stromschlag durch unbeabsichtigten Kontakt erhöht werden, indem weitere anwesende Personen den Notaus im Fehlerfall auslösen. Die verunfallte Person selbst kann in der Regel den Notaus nicht betätigen. Das bedingt aber, dass sich zumindest eine weitere Person in der Nähe eines Stromunfalles aufhält und auch Kenntnis vom Stromunfall erlangt, was aber nicht immer der Fall ist.

Andere übliche Sicherheitseinrichtungen in elektrischen Anlagen sind Sicherungsautomaten zum spannungsfrei Schalten von Stromkreisen im Falle eines unzulässigen elektrischen Stromes und Fehlerstromschutzschalter, die bei unzulässigen Erdfehlerströmen ansprechen sollen. Diese können aber, wenn vorhanden, nur dann Sicherheit geben, wenn diese im Fehlerfall tatsächlich ansprechen. Aufgrund von möglichen hohen Ansprechströmen oder langsamer Reaktionszeiten kann trotz solcher Sicherheitseinrichtungen eine Gefahr für an der Anlage arbeitende Personen bestehen.

Es sind daher schon Verfahren und Geräte zum besseren Schutz von Personen gegen unzulässige elektrische Körperströme bekannt geworden. Die DE 39 03 025 A1 beschreibt beispielsweise ein solches Verfahren und eine solche Einrichtung, wobei an zumindest zwei Extremitäten der Person, z.B. Armen oder Beinen, jeweils eine Elektrode angeordnet ist, die mit einem Steuergerät verbunden sind. Über die Elektroden wird durch das Steuergerät ein Körperstrom durch Kontakt eines elektrischen Fremdpotentials erfasst. Wird ein solcher Stromfluss erkannt, so aktiviert das Steuergerät eine Abschalteinrichtung, mit der die weitere Stromzufuhr in die Kontaktstelle unterbrochen wird. Die Elektroden und das Steuergerät können dabei an einem Kleidungsstück angeordnet sein und die Verbindung zwischen Steuergerät und Abschalteinrichtung kann kabellos ausgeführt sein. Eine ähnliche Sicherheitsvorrichtung zeigt die DE 44 38 063 A1 und auch die WO 2019/243388 A1.

Mit solchen Sicherheitsvorrichtungen kann die Sicherheit von an unter Spannung stehenden Teilen oder stromführenden Teilen arbeitenden Personen vor Stromschlag durch unbeabsichtigten Kontakt erhöht werden. Die Sicherheit ist aber natürlich an der korrekten Funktion einer solchen Sicherheitsbekleidung gekoppelt. Arbeitsbekleidung unterliegt beim Tragen aber hohen Belastungen und wird häufig von den Trägern wenig sorgfältig behandelt oder getragen. Das kann vor allem bei Elektroden problematisch sein, die in Kontakt mit der Haut der tragenden Person sein müssen, um eine ordnungsgemäße Funktion sicherzustellen. Das setzt voraus, dass die Elektroden korrekt angelegt sind, oder wenn diese in das Kleidungsstück integriert sind, dass das Kleidungsstück korrekt angelegt ist. Durch nicht ordnungsgemäß angelegte Elektroden wird die Funktion der Sicherheitsvorrichtungen jedoch zumindest beeinträchtigt, was von der tragenden Person möglicherweise nicht bemerkt wird. Gleichermaßen ist es ein Problem, dass sich der Kontaktwiderstand zwischen Elektrode und der Haut auch verändern kann, was ebenso die Messung eines Körperstromes und die Schutzfunktion beeinträchtigen kann. Das kann unter Umständen für die tragende Person noch gefährlicher sein, als gar keine Sicherheitsvorrichtungen, wenn diese bei den Arbeiten im Glauben eines sicheren Schutzes unter Umständen sehr unvorsichtig vorgeht.

Die WO 2019/243379 A1 zeigt eine Schutzvorrichtung gegen Stromschläge mit erhöhter Sicherheit, wobei jede Elektrode über zwei Leitungen mit einer Auswerteeinheit verbunden ist, sodass die Auswerteeinheit die Widerstände über die Elektroden ermitteln kann. Damit kann auf einen unzulässigen Zustand der Schutzvorrichtung geschlossen werden. Das korrekte Anliegen der Elektroden kann damit aber nicht erkannt werden.

Daher ist es aus der DE 27 09 815 A1 schon bekannt, bei einer Sicherheitsvorrichtung den Widerstand zwischen zwei Elektroden zum Kontakt mit der Haut der tragenden Person in gewissen Zeitabständen zu messen. Wenn der Widerstand einen gewissen Wert überschreitet, beispielsweise wenn eine Elektrode den Kontakt mit der Haut verliert, oder der Kontaktwiderstand zwischen Elektrode und Haut zu groß wird, steigt die Spannung zwischen den Elektroden und löst die Sicherheitsvorrichtung aus, wodurch die elektrische Anlage stromlos geschaltet wird. Der Nachteil dieser Ausführung ist, dass bei Kontaktverlust oder Kontaktverschlechterung einer Elektrode mit der Haut sofort die Sicherheitsvorrichtung ausgelöst wird, obwohl es möglicherweise gar keine Gefahr für den Träger der Sicherheitsvorrichtung gibt, insbesondere keinen Stromunfall gegeben hat. Der Kontakt kann beispielsweise schon dadurch unterbrochen oder verschlechtert werden, wenn sich der Kontaktwiderstand aufgrund gewisser Umstände (z.B. trockene Haut) ändert. Bei einer Ausführung einer Sicherheitsvorrichtung nach der DE 27 09 815 A1 kann es folgendermaßen zu unerwünschten Fehlauslösungen kommen, die zum Auslösen der Sicherheitsvorrichtung und damit zur elektrischen Unterbrechung in der Anlage führen würden. Wenn andererseits beispielsweise aufgrund eines schlechten Kontakts der Kontaktwiderstand an einer Elektrode steigt, z.B. weil die Elektrode verrutscht, und sich die Person in einem elektrischen Feld befindet (beispielsweise im Bereich einer Hochspannungsanlage) kann an einer Elektrode durch das elektrische Feld auch ein größeres Spannungspotential erzeugt werden, als an der anderen Elektrode. Die dadurch erzeugte Spannung zwischen den Elektroden kann auch zum Auslösen der Sicherheitsvorrichtung führen, obwohl kein Stromunfall passiert ist. Obwohl damit natürlich die Sicherheit für eine Person hoch ist, kann es zu oftmaligen unerwünschten Fehlauslösungen und damit verbundenen elektrischen Unterbrechungen in der elektrischen Anlage, in der die Person arbeitet, kommen. Derartige nicht gerechtfertigten Unterbrechungen durch Fehlauslösungen sind aber oftmals höchst unerwünscht und sind zu vermeiden.

Es ist daher eine Aufgabe der gegenständlichen Erfindung eine Sicherheitsvorrichtung für eine Person gegen Stromschlag durch unbeabsichtigten Kontakt mit unter Spannung stehenden oder stromführenden Teilen anzugeben, bei der unerwünschte Fehlauslösungen der Sicherheitsvorrichtung möglichst unterbunden werden.

Diese Aufgabe wird erfindungsgemäß nach den unabhängigen Ansprüchen 1 bzw. 4 dadurch gelöst, dass die Sicherheitsvorrichtung die Auslöseempfindlichkeit in Abhängigkeit vom ermittelten Körperwiderstand verändert. Damit kann erreicht werden, dass die Sicherheitsvorrichtung nur bei ordnungsgemäß angelegten und anliegenden Hautelektroden bei Auftreten eines detektierten unzulässigen Körperstromes auslöst. Fehlauslösungen durch nicht ordnungsgemäß angelegten oder anliegenden Hautelektroden können so weitestgehende vermieden werden.

Weitere vorteilhafte Ausgestaltungen und Wirkungen der Erfindung ergeben sich aus den abhängigen Ansprüchen und der nachfolgenden Beschreibung.

Die gegenständliche Erfindung wird nachfolgend unter Bezugnahme auf die Figuren 1 bis 5 näher erläutert, die beispielhaft, schematisch und nicht einschränkend vorteilhafte Ausgestaltungen der Erfindung zeigen. Dabei zeigt
Fig.1 eine für die Erfindung verwendete Sicherheitsvorrichtung,
Fig.2 eine Sicherheitsvorrichtung mit zwei Hautelektroden an einem Bekleidungsstück,
Fig.3 eine Anordnung zur Messung eines Körperwiderstandes über die Hautelektroden,
Fig.4 die parallele Ermittlung des Körperwiderstandes und Erzeugung eines Notsignals und
Fig.5 eine Sicherheitsvorrichtung ohne Bekleidungsstück.

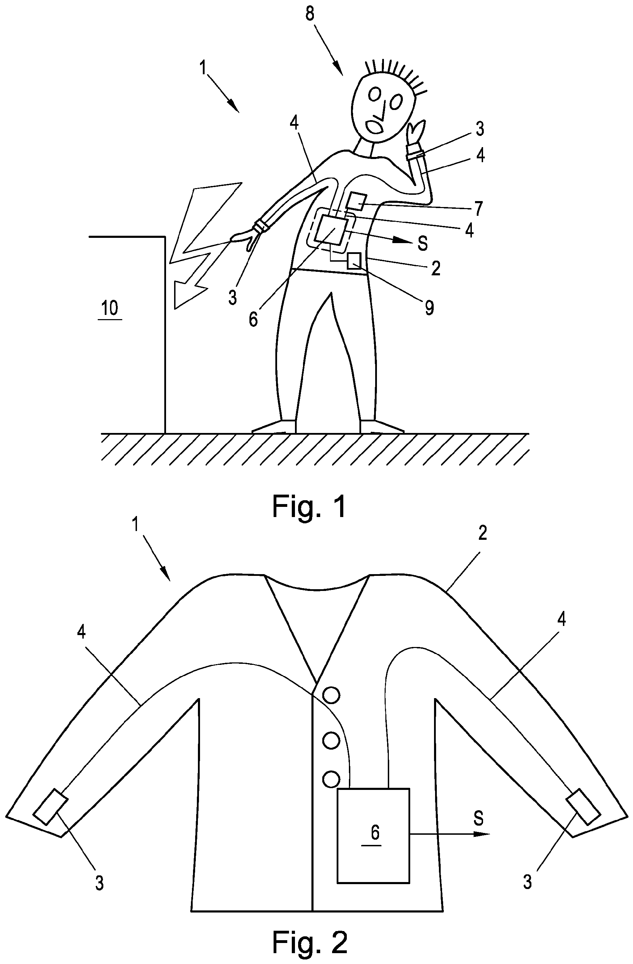

Die gegenständliche Erfindung nutzt eine Sicherheitsvorrichtung 1, die in ihrer grundlegenden Funktion aus dem Stand der Technik bekannt ist, und die mit Bezugnahme auf die Fig.1 und 2 zum besseren Verständnis näher erläutert wird. Die Sicherheitsvorrichtung 1 dient dazu, die Sicherheit für eine im Umfeld einer elektrischen Anlage 10 arbeitende Person 8 zu erhöhen, insbesondere hinsichtlich elektrischer Stromunfällen der Person 8 durch unbeabsichtigtes Kontaktieren eines unter elektrischer Spannung stehenden oder stromführenden Teils der elektrischen Anlage 10. Die Sicherheitsvorrichtung 1, oder zumindest Teile davon, ist vorzugsweise an einem Bekleidungsstück 2 angeordnet oder integriert. Als Bekleidungsstück 2 kommt insbesondere ein Oberbekleidungsstücke in Frage, wie z.B. ein Hemd, eine Hose, ein Pullover, ein T-Shirt, eine Jacke, ein Overall, usw. Auch Kombinationen mehrerer Teile kommen als Bekleidungsstück 2 in Frage, z.B. eine Kombination aus Hose und Hemd, usw. Am Bekleidungsstück 2 sind zumindest zwei Hautelektroden 3 angeordnet, um einen durch den menschlichen Körper der tragenden Person 8 fließenden elektrischen Körperstrom zu detektieren. Mit einer Hautelektrode 3 wird beispielsweise ein elektrisches Potential erfasst, um damit einen elektrischen Strom oder eine elektrische Spannung zwischen zwei Hautelektroden 3, die auf unterschiedlichen elektrischen Potentialen liegen, zu erfassen. Die Hautelektroden 3 sind vorzugsweise an exponierten Stellen des Bekleidungsstückes 2 angeordnet, beispielsweise im Bereich von Extremitäten der Person 8, also beispielsweise an Ärmeln, Hosenbeinen oder Kapuzen. An der Sicherheitsvorrichtung 1 können auch noch weitere Sensoren vorgesehen sein, wie ein biometrischer Sensor 7 zur Erfassung eines biometrischen Signals, beispielsweise die Frequenz des Herzschlages einer Person, die Amplitude oder den Verlauf des Herzschlages, die Atemfrequenz, den Hautwiderstand, usw. Durch Auswertung des biometrischen Signals, insbesondere des Herzschlages (Frequenz, Amplitude und/oder Verlauf), kann ebenfalls auf einen fließenden elektrischen Körperstrom geschlossen werden, oder es kann auf den Gesundheitszustand der tragenden Person 8 rückgeschlossen werden.

Die Hautelektroden 3, und gegebenenfalls auch weitere Sensoren 7, sind vorzugsweise im Bekleidungsstück 2 integriert, können aber auch getrennt vom Bekleidungsstück 2 angelegt werden, beispielsweise mittels einer Manschette, eines Armbands oder eines Gurtes.

Die zumindest zwei Hautelektroden 3 sind jeweils über zumindest eine Signalleitung 4 mit einer Auswerteeinheit 6 verbunden. Ebenso kann ein weiterer Sensor 7 (falls vorhanden) mittels einer Signalleitung mit der Auswerteeinheit 6 verbunden sein. In der Auswerteeinheit 6 werden die mit den Hautelektroden 3, und möglicher weiterer Sensoren, erfassten Messsignale ausgewertet. Beispielsweise kann ein mit einer Hautelektrode 3 erfasstes elektrisches Potential oder ein erfasster fließender elektrischer Strom ausgewertet werden. Zwischen zwei, beispielsweise mit zwei Hautelektroden 3, erfassten elektrischen Potentialen kann eine anliegende elektrische Spannung ermittelt und in der Auswerteeinheit 6 ausgewertet werden. Die Auswertung kann analog mit geeigneten elektrischen Schaltungen oder digital, was eine A/D-Wandlung und entsprechende Hardware und Software erforderlich macht, erfolgen. Die Auswerteeinheit 6 kann im Falle eines erkannten gefährlichen Körperstromes, beispielsweise bei einem abnormalen Herzschlag, einem erfassten gefährlichen Körperstrom oder einer gefährlichen Potentialdifferenz (Spannung) zwischen zwei Hautelektroden 3, was wiederum zu einem elektrischen Körperstrom durch den Körper führt, die Sicherheitsvorrichtung 1 auslösen. Beim Auslösen kann die Sicherheitsvorrichtung 1 beispielsweise ein Notsignal S erzeugen, das genutzt werden kann, um eine gewünschte Aktion auszulösen. Das Notsignal S kann grundsätzlich kabelgebunden oder kabellos ausgegeben werden. Hierzu können in der Auswerteeinheit 6 natürlich auch entsprechende Grenzwerte für einen zulässigen Körperstrom, beispielsweise für eine zulässige elektrische Potentialdifferenz oder einen zulässigen elektrischen Strom, hinterlegt oder vorgegeben werden, die auch änderbar sein können. Ebenso können in der Auswerteeinheit 6 auch Muster eines biometrischen Signals hinterlegt sein, die auf einen gefährlichen Körperstrom schließen lassen. Die Sicherheitsvorrichtung 1, z.B. über die Auswerteeinheit 6, kann aber beim Auslösen auch einen gefährlichen Körperstrom anzeigen, beispielsweise akustisch, visuell oder palpabel.

Die Auswerteeinheit 6 kann in Form einer mikroprozessorbasierten Recheneinheit, gegebenenfalls auch mit entsprechender Software, einer anwendungsspezifischen integrierten Schaltung (ASIC) oder eines Field Programmable Gate Array (FPGA) oder ähnlichem ausgeführt sein. Die Auswerteeinheit 6 kann aber auch als analoge elektrische Schaltung ausgeführt sein. Auch Mischformen sind denkbar. Die Auswerteeinheit 6 kann auch auf mehrere solcher Einheiten aufgeteilt sein.

Die Sicherheitsvorrichtung 1, kann in einer elektrischen Anlage 10, in deren Bereich die Person 8 tätig ist, genutzt werden, um beim Auslösen der Sicherheitsvorrichtung 1 bestimmte konfigurierte Handlungen zu setzen, um die Sicherheit einer Person 8 gegen Stromschlag zu erhöhen. Dabei kommen als Handlungen ein einfaches Anzeigen gefährlicher Körperströme in Frage, genauso wie Schalthandlungen in der elektrischen Anlage 10 zur Anwendung, um die elektrische Anlage 10 oder Teile davon spannungsfrei zu schalten. Schalthandlungen können beispielsweise durch das von der Sicherheitsvorrichtung 1 abgesetzte Notsignal S ausgelöst werden.

Das spannungsfrei Schalten der elektrischen Anlage 10, oder eines Teiles davon, kann natürlich auf verschiedene Weise realisiert werden. Beispielsweise könnte ein Schalter aktiviert werden, um einen Stromkreis vom Versorgungsnetz zu trennen, wobei der Schalter auch ein vorhandener Not-Aus Schalter der elektrischen Anlage 10 sein kann. Ebenso könnte ein Stromkreis kurzgeschlossen werden (beispielsweise durch Verbinden einer Phase mit dem Nullleiter), um einen Sicherungsautomaten auszulösen, um so den Stromkreis vom Netz zu trennen. Ebenso könnte ein ausreichend hoher Erdfehlerstrom erzeugt werden (beispielsweise durch Verbinden einer Phase über einen Widerstand mit Erde), um einen Fehlerstromschutzschalter auszulösen. Daneben gibt es aber natürlich auch noch andere Möglichkeiten, um die elektrische Anlage 10, oder Teile davon, spannungsfrei zuschalten.

In vorteilhafter Weise können am Bekleidungsstück 2 verschiedene Sensoren vorgesehen sein, um die Sicherheit der Erkennung von gefährlichen elektrischen Körperströmen zu erhöhen. Beispielsweise könnten zumindest zwei Hautelektroden 3 an Extremitäten vorgesehen sein und zusätzlich ein biometrischer Sensor 7 zur Erfassung des Herzschlages, wie in Fig.1 dargestellt.

Ebenso kann durch Vorsehen von Redundanzen die Sicherheit der Sicherheitsvorrichtung 1 erhöht werden. Beispielsweise kann pro Sensor oder pro Hautelektrode 3 mehr als eine Signalleitung 4 vorgesehen sein, wodurch mögliche Kabelbrüche oder Kontaktfehler nicht zum Ausfall der Sicherheitsfunktion führen müssen oder ein Kabelbruch oder Kontaktfehler sogar erkannt, und gegebenenfalls auch angezeigt, werden kann.

Die Auswerteeinheit 6 wird vorzugsweise von der Person 8, die die Sicherheitsvorrichtung 1 trägt, gehalten oder getragen. Beispielsweise könnte diese in einer Umhängetasche oder einem Rucksack angeordnet sein, könnte aber auch in einer Tasche des Bekleidungsstückes 2 gesteckt sein oder könnte vorteilhafterweise, ganz oder teilweise, auch im Bekleidungsstück 2 integriert sein, beispielsweise in Form eines intelligenten Kleidungstückes mit integrierter Elektronik (wie in Fig.2 angedeutet).

Die erfindungsgemäße Sicherheitsvorrichtung 1 hat zumindest zwei Hautelektroden 3, die für eine ordnungsgemäße Funktion in elektrisch leitfähigem Kontakt mit der Haut der tragenden Person 8 sein müssen. Beide Hautelektroden 3 sind über jeweils zumindest eine Signalleitung 4 mit der Auswerteeinheit 6 verbunden, sodass zwischen den beiden Hautelektroden 3 in der Auswerteeinheit 6 eine anliegende elektrische Spannung oder ein elektrischer Strom gemessen werden kann. Es ist natürlich egal wo die beiden Hautelektroden 3 am menschlichen Körper angeordnet sind, wobei sich aber insbesondere Extremitäten für eine Anordnung eignen, beispielsweise an beiden Armen oder an einem Arm und einem Bein. Insbesondere können auch mehr als zwei Hautelektroden 3 vorgesehen sein.

Die Hautelektroden 3 sind vorzugsweise in einem Bekleidungsstück 2 integriert (z.B. wieder in Form eines intelligenten Kleidungstückes), können aber auch separat angelegt werden, beispielsweise mittels einer Manschette, eines Armbands oder eines Gurtes.

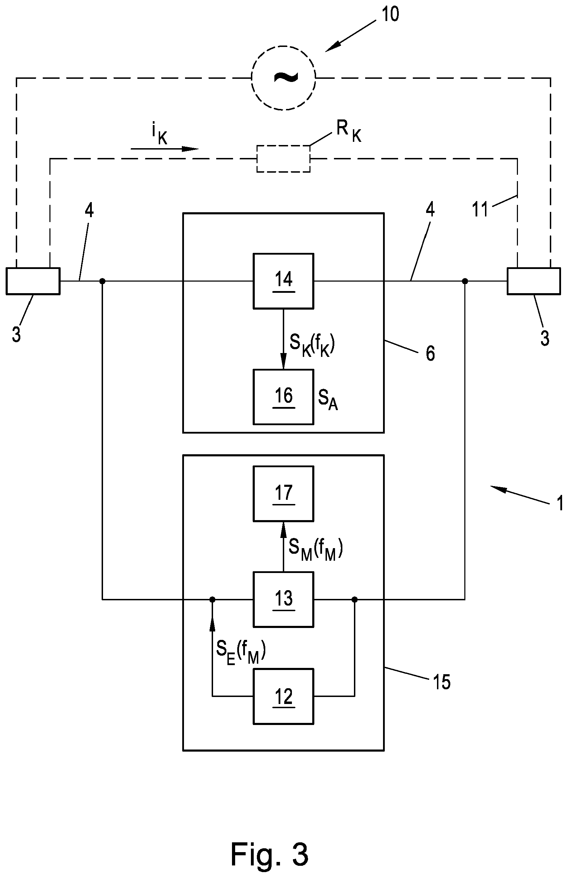

Der Körper der Person 8 schließt einen elektrischen Stromkreis 11 zwischen zumindest zwei Hautelektroden 3, wie in Fig.3 strichliert angedeutet. Um einen zwischen den zumindest zwei Hautelektroden 3 fließenden gefährlichen elektrischen Körperstrom i_{K} zu erfassen, ist in der Auswerteeinheit 6 eine Messeinheit 14 vorgesehen, die mit den zumindest zwei Hautelektroden 3 verbunden ist. Der elektrische Körperstrom i_{K} wird beispielsweise durch Kontaktierung eines spannungsführenden oder stromführenden Teils der elektrischen Anlage 10 (wie in Fig.3 als Spannungsquelle strichliert angedeutet) verursacht. Mit der Messeinheit 14 wird ein erstes elektrisches Messsignal S_{K}(f_{K}) in einem vorgegebenen Messfrequenzbereich f_{K} erfasst. Das Messsignal S_{K}(f_{K}) wird in einer

Messsignalauswerteeinheit 16 (Hardware wie Mikroprozessor, ASIC, FPGA oder ähnliches, oder Software) der Auswerteeinheit 6 ausgewertet, um ein Auswertesignal S_{A} zu erhalten. Die Messeinheit 14 und die Auswerteeinheit 6 könnten aber auch getrennt voneinander ausgeführt sein. Die Messeinheit 14 würde dann der Auswerteeinheit 6 das Messsignal S_{K} in geeigneter Weise zur Verfügung stellen. Die Messsignalauswerteeinheit 16 ist vorzugsweise als Software auf der Auswerteeinheit 6 ausgeführt.

Der Messfrequenzbereich f_{K} ist vorzugsweise ein Frequenzbereich, in dem elektrische Signale in der elektrischen Anlage 10 erwartet werden. Sinnvollerweise umfasst der Messfrequenzbereich f_{K} somit eine Netzfrequenz der elektrischen Anlage 10, beispielsweise 50Hz oder 60Hz. In gewissen Anwendungsbereichen kommen aber auch andere Frequenzen vor, beispielsweise 16.7Hz in einem elektrischen Eisenbahnnetz. Damit die Sicherheitsvorrichtung 1 flexibel einsetzbar ist, wird folglich vorzugsweise ein ganzer Messfrequenzbereich f_{K} überwacht, beispielsweise Frequenzen kleiner 100Hz, wobei auch eine Frequenz f_{K} = 0Hz umfasst sein kann (also Gleichgrößen). Ebenso sei angemerkt, dass der Messfrequenzbereich f_{K} auch nur eine einzige ausgewählte Frequenz umfassen kann, beispielsweise eine Netzfrequenz eines Versorgungsnetzes, beispielsweise 50 Hz. Der Messfrequenzbereich f_{K} kann durch geeignete Filterung des ersten Messsignals S_{K} eingestellt werden.

Das Auswertesignal S_{A} wiederum hängt von der Art und Weise der Auswertung des Messignals S_{K} ab. Grundsätzlich kann das Messsignals S_{K} im Zeitbereich oder Frequenzbereich, oder auch beides, verarbeitet werden. Die Auswertung könnte auch die Filterung des ersten Messsignals S_{K} auf den vorgegebenen Messfrequenzbereich f_{K} umfassen. Im Zeitbereich könnte beispielsweise eine Maximalwertermittlung des Messsignals S_{K} im Messfrequenzbereich f_{K} in einer bestimmten Zeitspanne (beispielsweise eine Periode einer Wechselgröße mit bestimmter Frequenz) erfolgen, um als Auswertesignal S_{A} den Maximalwert zu ermitteln. Ebenso könnte aber auch die elektrische Energie oder Leistung des Messsignals S_{K} ermittelt werden. Das Auswertesignal S_{A} wäre dann eine elektrische Energie oder Leistung. Für eine Auswertung im Frequenzbereich könnte das Messsignals S_{K} einer Fouriertransformation (z.B. FFT) unterworfen werden und dann die verschiedenen Frequenzen oder Frequenzbänder ausgewertet werden. Beispielsweise könnte wieder eine Maximalwertermittlung erfolgen.

Die Auswerteeinheit 6 hat für das Auswertesignal S_{A} eine vorgegebene zugeordnete Auslöseempfindlichkeit E_{A}, die festlegt, wann die Sicherheitsvorrichtung 1 in Abhängigkeit vom Auswertesignal S_{A} auslöst, beispielsweise wenn das Auswertesignal S_{A} die Auslöseempfindlichkeit E_{A} überschreitet (auch im Sinne eines Unterschreitens). Die Auslöseempfindlichkeit E_{A} ist natürlich an das Auswertesignal S_{A} und die Art und Weise der Auswertung des Messsignals S_{K} gekoppelt. Bei Auslösen der Sicherheitsvorrichtung 1, beispielsweise wenn ein unzulässiger elektrische Körperstrom i_{K} erfasst wird, wird beispielsweise ein Notsignal S ausgegeben und/oder ein Warnsignal erzeugt und der Person angezeigt (akustische, visuell, palpabel) und/oder eine andere konfigurierte Handlung, vorzugsweise in der elektrischen Anlage 10, ausgelöst.

In einem Ausführungsbeispiel wird als Messsignals S_{K} eine elektrische Spannung bei Netzfrequenz erfasst (im Zeit- oder Frequenzbereich). Als Auswertesignal S_{A} wird die Maximalspannung in einer Netzperiode (also die Amplitude der Wechselgröße) erfasst, was mit einem fließenden Körperstrom i_{K} gleichgesetzt werden kann. Als Auslöseempfindlichkeit E_{A} ist eine Grenzspannung vorgegeben. Überschreitet die erfasste Maximalspannung die Grenzspannung, wird die Sicherheitsvorrichtung 1 ausgelöst. Alternativ könnte auch ein elektrischer Strom bei Netzfrequenz erfasst werden und mit einem Grenzstrom als Auslöseempfindlichkeit E_{A} verglichen werden.

Um zu überprüfen, ob die Hautelektroden 3 ordnungsgemäß an der Haut anliegen, ist vorgesehen, dass der Körperwiderstand R_{K} (auch im Sinne einer Körperimpedanz) der Person 8 zwischen den beiden Hautelektroden 3 gemessen wird, wie anhand der Fig.3 erläutert wird. Durch den Stromkreis 11 kann bei Anlegen einer elektrischen Spannung an die Hautelektroden 3 und Messen des Stromflusses der Körperwiderstand R_{K} ermittelt werden kann. Ebenso kann natürlich über die Hautelektroden 3 ein elektrischer Strom eingeprägt werden und die elektrische Spannung zwischen den beiden Hautelektroden 3 gemessen werden.

Für die Messung des Körperwiderstandes R_{K} zwischen den beiden Hautelektroden 3 werden vorzugsweise elektrische Wechselgrößen verwendet. Es können aber auch Gleichgrößen (wie eine Gleichspannung und Gleichstrom) verwendet werden. Allgemein wird zur Ermittlung des Körperwiderstandes R_{K} ein elektrisches Einspeisesignal S_{E}(f_{M}) (elektrische Spannung oder elektrischer Strom) mit einer Einspeisefrequenz f_{M} verwendet. Mit einer Messeinrichtung 13 wird ein Messsignal S_{M}(f_{M}) (elektrischer Strom oder elektrische Spannung) bei dieser Einspeisefrequenz f_{M} erfasst und aus dem Einspeisesignal S_{E}(f_{M}) und dem Messsignal S_{M}(f_{M}) wird der Körperwiderstand R_{K} (was auch eine Impedanz sein kann) ermittelt, in der Regel als Quotient aus den beiden Signalen. Die Einspeisefrequenz f_{M} ist eine geeignete Frequenz, wobei damit Wechselgrößen mit f_{M} > 0Hz, als auch Gleichgrößen, also f_{M} = 0Hz, umfasst sein sollen. Grundsätzlich könnte auch in einem Frequenzbereich eingespeist werden, also mehrere Frequenzen. Dann könnte der Körperwiderstand R_{K} auch bei verschiedenen Frequenzen ermittelt werden, die dann auch gemittelt werden könnten.

Beispielsweise ist in der Sicherheitsvorrichtung 1 eine Widerstandsmesseinrichtung 15 vorgesehen mit einer elektrischen Energiequelle 12 (eine Spannungsquelle oder eine Stromquelle, typischerweise eine spannungsbegrenzte Stromquelle), um ein elektrisches Einspeisesignal S_{E}(f_{M}) mit der vorgegebenen Einspeisefrequenz f_{M}, beispielsweise eine elektrische Spannung und/oder ein elektrischer Strom, in den entstehenden Stromkreis 11 einzuspeisen. Mit einer Messeinheit 13 (eine Strommesseinheit oder eine Spannungsmesseinheit) der Sicherheitsvorrichtung 1 wird ein Messsignal S_{M}(f_{M}) bei der Einspeisefrequenz f_{M} erfasst, beispielsweise ein durch das Einspeisesignal S_{E}(f_{M}) hervorgerufener elektrischer Strom oder elektrische Spannung. Die Energiequelle 12 ist zum Einspeisen beispielsweise parallel zur Messeinheit 13 geschaltet. Das Einspeisen des Einspeisesignal S_{E}(f_{M}) zur Ermittlung des Körperwiderstandes R_{K} kann permanent oder in gewissen Zeitabständen erfolgen. Der Körperwiderstand R_{K} (auch als Impedanz) kann dann bei der Einspeisefrequenz f_{M} in einer Widerstandauswerteeinheit 17 aus dem Einspeisesignal S_{E}(f_{M}) und dem Messsignal S_{M}(f_{M}) ermittelt werden, beispielsweise einfach aus dem Ohm'schen Gesetz (unter der vereinfachten Annahme eines rein ohmschen Widerstandes).

Die Widerstandsmesseinrichtung 1 ist bevorzugt parallel zur Auswerteeinheit 6 angeordnet wie in Fig.3, könnte aber auch in Serie dazu geschaltet sein.

Die Widerstandsmesseinrichtung 15, oder Teile davon wie z.B. die Widerstandauswerteeinheit 17, kann auch in der Auswerteeinheit 6 integriert sein, beispielsweise als Software oder als eigener FPGA, ASIC, Mikroprozessor, elektrische Schaltung oder ähnliches. Vorzugsweise ist die Widerstandsmesseinrichtung 15 in das Bekleidungsstück 2 integriert (z.B. wieder in Form eines intelligenten Kleidungstückes).

Das Einspeisesignal S_{E}(f_{M}) (Spannung oder Strom) wird mit einer bestimmten vorgegebenen Einspeisefrequenz f_{M} eingespeist, die sich vom Messfrequenzbereich f_{K} der Sicherheitsvorrichtung 1 unterscheidet. Bei Verwendung einer Einspeisefrequenz f_{M} ungleich dem Messfrequenzbereich f_{K} kann die Ermittlung des Körperwiderstandes R_{K} gleichzeitig mit der Überwachungsfunktion der Sicherheitsvorrichtung 1 erfolgen. Wenn als Messfrequenzbereich f_{K} beispielsweise der Bereich der Frequenzen kleiner 100Hz gewählt wird könnte die Einspeisefrequenz f_{M} zum Messen des Körperwiderstandes R_{K} beispielsweise im kHz-Bereich liegen, z.B. 1kHz. Damit ist eine zuverlässige Trennung der Überwachungsfunktion und der Widerstandsmessung möglich.

Als Einspeisesignal S_{E}(f_{M}) wird vorzugsweise ein sehr kleines elektrisches Signal gewählt, das lediglich so groß sein muss, sodass eine zuverlässige frequenzselektive Erfassung in der Messeinheit 13 möglich ist. Typischerweise wird als Einspeisesignal S_{E}(f_{M}) eine elektrische Spannung im Bereich von einigen Millivolt eingespeist oder ein elektrischer Strom im Mikroamperebereich.

In einer bevorzugten Ausgestaltung wird über die zumindest zwei Hautelektroden 3 von der Energiequelle 12 als Einspeisesignal S_{E}(f_{M}) ein elektrischer Strom mit der vorgesehenen Einspeisefrequenz f_{M} in den Stromkreis 11 eingespeist und es wird die über den Körperwiderstand R_{K} auftretenden elektrische Spannung von der Messeinheit 13 als Messsignal S_{M}(f_{M}) gemessen. Daraus wird der Körperwiderstand R_{K} bei dieser Einspeisefrequenz f_{M} ermittelt.

Die Messeinheit 13 der Widerstandsmesseinrichtung 15 und die Messeinheit 14 zur Überwachung des Körperstromes i_{K} könnte auch in einer einzigen Messeinheit zusammengefasst sein. In einer gemeinsamen Messeinheit könnten dazu Filter vorgesehen sein, um das mit der Messeinheit erfasste elektrische Signal, beispielsweise eine elektrische Spannung oder ein elektrischer Strom, frequenzselektiv in das Messsignals S_{K}(f_{K}) im Messfrequenzbereich f_{K} und das Messsignal S_{M}(f_{M}) bei der Einspeisefrequenz f_{M} zu trennen.

Gleichfalls könnten die Messsignalauswerteeinheit 16 und die Widerstandauswerteeinheit 17 in einer gemeinsamen Einheit realisiert sein, beispielsweise beide als Software auf einem Mikroprozessor der Auswerteeinheit 6.

Es kann in der Sicherheitsvorrichtung 1 ein Grenzwiderstand R_{G} (auch im Sinne einer Grenzimpedanz) festgelegt sein, ab dem man von einer nicht ordnungsgemäßen Kontaktierung zwischen einer Hautelektrode 3 und der Haut der tragenden Person 8 ausgehen kann. Der Grenzwiderstand R_{G} kann beispielsweise in der Auswerteeinheit 6 oder der Widerstandsmesseinrichtung 15 hinterlegt und könnte auch änderbar sein.

Wird durch die Ermittlung des Körperwiderstandes R_{K} eine nicht ordnungsgemäße Kontaktierung der Hautelektroden 3 mit der Haut der Person 8 festgestellt (beispielsweise durch Vergleich mit einem Grenzwiderstand R_{G}), kann die Sicherheitsvorrichtung 1 ein Warnsignal W ausgeben, beispielsweise ein akustisches, visuelles oder palpables Signal, um die tragende Person 8 von der nicht ordnungsgemäßen Funktion der Sicherheitsvorrichtung 1 zu informieren. Alternativ oder zusätzlich kann bei Feststellen eines unzulässigen Körperwiderstandes R_{K} auch das Notsignal S erzeugt und ausgegeben werden oder eine andere konfigurierte Handlung gesetzt werden.

Aus der oben beschriebenen Funktion der Sicherheitsvorrichtung 1 ist offensichtlich, dass ein fehlender oder schlechter Kontakt einer Hautelektrode 3 mit der Haut der tragenden Person 8 über den ermittelten Körperwiderstandes R_{K} erkannt werden kann. Die Sicherheitsvorrichtung 1 kann diesen Zustand in geeigneter Weise anzeigen, kann aber aus Sicherheitsgründen nicht die Erfassung eines gefährlichen Körperstromes i_{K} in Folge einer unbeabsichtigten Kontaktierung eines Fremdpotential in der elektrischen Anlage 10 durch die Person 8 einstellen. Es könnte ja sein, dass eine Hautelektrode 3 durch eine Bewegung der Person 8 nur kurz verrutscht und sich dadurch der Kontaktwiderstand zwischen Hautelektrode 3 und der Haut erhöht, was sich in einer Erhöhung des erfassten Körperwiderstandes R_{K} bemerkbar machen würde. Solche kurzfristigen Störungen der Sicherheitsvorrichtung 1 sollen aber nicht zum Auslösen der Sicherheitsvorrichtung 1 (Erzeugen eines Warnsignals und/oder Notsignals S und/oder andere konfigurierte Handlung) führen, was die tragende Person irritieren kann und/oder zum spannungsfrei Schalten der elektrischen Anlage 10, oder eines Teiles davon, führen kann. In diesem Zustand einer nicht ordnungsgemäßen Kontaktierung einer Hautelektrode 3 sind aber Fehlauslösungen der Sicherheitsvorrichtung 1 möglich.

Eine Person 8, die eine erfindungsgemäße Sicherheitsvorrichtung 1 trägt, arbeitet üblicherweise im Bereich einer elektrischen Anlage 10, oftmals auch eine Mittelspannungs- oder Hochspannungsanlage. In Bereich elektrischer Anlagen 10 können elektrische Felder auftreten, die elektrische Potentiale im Umfeld der elektrischen Anlage 10 erzeugen können. Eine Hautelektrode 3 ohne oder mit schlechtem Kontakt zur Haut einer Person 8 im Bereich solcher elektrischer Felder erfasst ein durch das elektrische Feld erzeugtes elektrisches Potential. Das kann zu einer Potentialdifferenz zwischen den beiden Hautelektroden 3 führen und in weiterer Folge zur Erfassung eines Messsignals S_{K}, z.B. einer elektrischen Spannung, durch die Messeinheit 14. Die elektrischen Potentiale in solchen elektrischen Feldern können ausreichend groß werden, sodass die Auswerteeinheit 6 auf einen gefährlichen Körperstrom i_{K} schließt und die Sicherheitsvorrichtung 1 auslöst. Dabei handelt es sich aber um eine unerwünschte Fehlauslösung, weil keine gefährliche Situation vorliegt. Dieses Problem kann auch auftreten, wenn beide Hautelektroden 3 die Haut nicht oder nur schlecht kontaktieren. Das elektrische Feld nimmt bekanntermaßen mit dem Abstand ab, sodass an den beiden Hautelektroden 3 durchaus für eine Auslösung der Sicherheitsvorrichtung 1 hinreichend große, unterschiedliche, durch das elektrische Feld hervorgerufene elektrische Potentiale anliegen können. Bei ordnungsgemäß kontaktierten Hautelektroden 3 tritt dieses Problem nicht auf, weil sich dann der ganze Körper 8 im elektrischen Feld befindet und der Körper 8 im Wesentlichen auf demselben elektrischen Potential liegt.

Um solche Fehlauslösungen zu vermeiden ist vorgesehen, dass die Auslöseempfindlichkeit E_{A} der Sicherheitsvorrichtung 1 in Abhängigkeit vom erfassten Körperwiderstandes R_{K} verändert wird.

Steigt der Körperwiderstand R_{K} an, beispielsweise weil sich der Kontakt zwischen Hautelektrode 3 und der Haut verschlechtert oder der Kontakt ganz verloren geht, wird die Auslöseempfindlichkeit E_{A} beispielsweise verringert, sodass möglicherweise auftretende elektrische Felder im Umfeld der Person 8 zu keiner Fehlauslösung der Sicherheitsvorrichtung 1, und damit in weiterer Folge zu keiner Fehlabschaltung der elektrischen Anlage 10, oder eines Teils davon, führen können.

Die schlechte Kontaktierung kann wie oben ausgeführt der Person 8, die die Sicherheitsvorrichtung 1 trägt, angezeigt werden.

Die Sicherheitsvorrichtung 1 kann aber in diesem Zustand möglicherweise nicht mehr die Überwachungsfunktion von gefährlichen Körperströmen i_{K} aufrecht halten. Es liegt daher gegebenenfalls in der Verantwortung der Person 8 auf die Warnung bei schlechtem Kontakt zu reagieren und die Hautelektroden 3 zu prüfen.

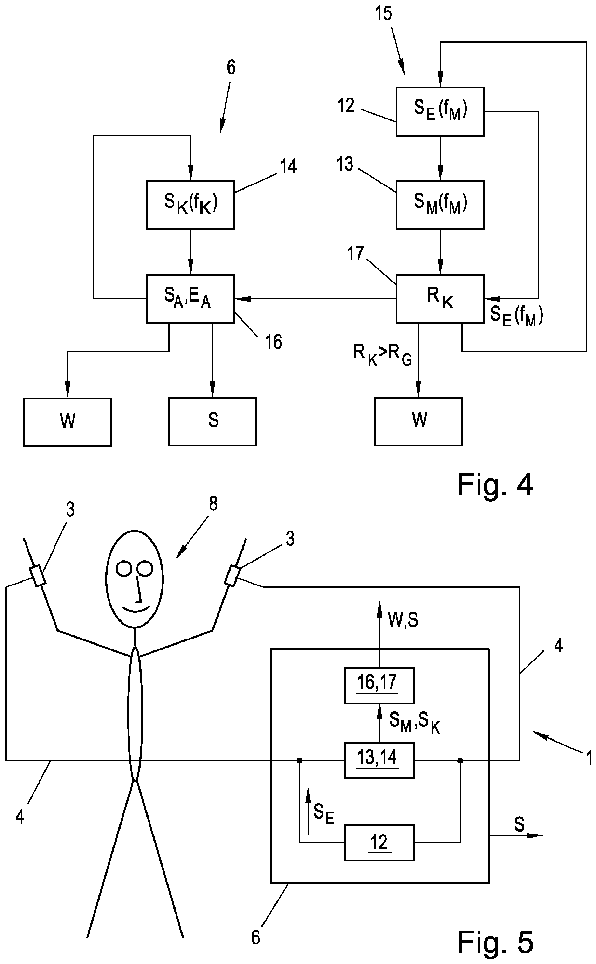

In der Sicherheitsvorrichtung 1 laufen damit die Ermittlung des Körperwiderstandes R_{K} und die Überwachung auf gefährliche Körperströme i_{K} gleichzeitig, wie anhand von Fig.4 erläutert wird. Hierfür kann wie oben bereits erwähnt eine gemeinsame Auswerteeinheit 6 vorgesehen sein, oder es können auch getrennte Hardwareeinheiten vorgesehen sein, beispielsweise eine Auswerteeinheit 6 und eine separate Widerstandsmesseinrichtung 15.

Es wird durch Einspeisen eines elektrischen Einspeisesignals S_{E}(f_{M}) bei einer Einspeisefrequenz f_{M} über die Hautelektroden 3, beispielsweise ein elektrischer Strom (oder auch eine elektrische Spannung), und Erfassen eines elektrischen Messsignals S_{M}(f_{M}) bei dieser Frequenz f_{M}, beispielsweise eine elektrische Spannung oder eines elektrischen Stromes, ein Körperwiderstand R_{K} der die Sicherheitsvorrichtung 1 tragenden Person 8 ermittelt. Das Einspeisen kann durch eine Energiequelle 12 (Fig.3) erfolgen und das Erfassen des Messignale S_{M} durch eine Messeinheit 13 (Fig.3). Das Erfassen des Körperwiderstandes R_{K} erfolgt laufend (z.B. durch einen analogen Schaltkreis oder in diskreten Abtastschritten) oder regelmäßig zu bestimmten vorgegebenen Zeitpunkten. Parallel dazu wird ein weiteres elektrisches Messsignal S_{K}(f_{K}) zwischen den Hautelektroden 3 im vorgegebenen Messfrequenzbereich f_{K} erfasst, beispielsweise eine elektrische Spannung oder ein elektrischer Strom. Die Erfassung erfolgt durch eine Messeinheit 14. Die Messeinheit zur Erfassung der Messsignale S_{M}, S_{K} bei den unterschiedlichen Frequenzen f_{K}, f_{M} kann die gleiche sein, oder es können auch separate Messeinheiten vorgesehen sein. Aus dem Messsignal S_{K}(f_{K}) im Messfrequenzbereich f_{K} wird ein Auswertesignal S_{A} ermittelt. Erreicht das Auswertesignal S_{A} die vorgegebene Auslöseempfindlichkeit E_{A} der Sicherheitsvorrichtung 1 wird die Sicherheitsvorrichtung 1 ausgelöst, also beispielsweise ein Warnsignal W und/oder ein Notsignal S erzeugt und ausgegeben und/oder eine andere konfigurierte Sicherheitshandlung gesetzt. Im Betrieb der Sicherheitsvorrichtung 1 wird die Auslöseempfindlichkeit E_{A} in Abhängigkeit vom erfassten Körperwiderstand R_{K} geändert. Steigt der Körperwiderstand R_{K} an, dann wird die Auslöseempfindlichkeit E_{A} beispielsweise erhöht und umgekehrt.

Die Abhängigkeit der Auslöseempfindlichkeit E_{A} vom Körperwiderstand R_{K} kann in der Sicherheitsvorrichtung 1, beispielsweise in einem Speicher der Auswerteeinheit 6 oder der Messsignalauswerteeinheit 16, hinterlegt sein, beispielsweise in Form einer Tabelle, einer Funktion, eines mathematischen Modells usw. Diese Abhängigkeit kann beispielsweise empirisch ermittelt werden oder auch anhand physikalischer Zusammenhänge berechnet oder simuliert werden, wird aber als bekannt vorausgesetzt.

Beispielsweise könnte die Auslöseempfindlichkeit E_{A} in zwei Bereiche unterteilt sein. Wenn der Körperwiderstand R_{K} unter 1 MΩ liegt könnte die Auslöseempfindlichkeit E_{A} auf 2 Volt (bei einer elektrischen Spannung als Auswertesignal S_{A}) eingestellt werden. Bei einem erfassten Auswertesignal S_{A} von über 2 Volt zwischen den Hautelektroden 3 würde dann die Sicherheitsvorrichtung 1 ausgelöst, beispielsweise ein Notsignal S ausgegeben, werden. Bleibt das Auswertesignal S_{A} unterhalb der Auslöseempfindlichkeit E_{A} von 2 Volt, löst die Sicherheitsvorrichtung 1 nicht aus. Bei einem erfassten Körperwiderstand R_{K} über 1 MΩ wird die Auslöseempfindlichkeit S_{A} beispielsweise auf unendlich eingestellt. Damit würde die Sicherheitsvorrichtung 1 unabhängig vom Auswertesignal S_{A} nie ausgelöst. Unabhängig davon könnte aber nach einer vorgegebenen Zeitspanne, beispielsweise nach einigen Minuten, ein Warnsignal W ausgegeben werden, um die Person 8 zu informieren, dass kein Schutz mehr vorliegt.

Natürlich sind auch mehrstufige oder stufenlose Charakteristiken denkbar bei denen die Auslöseempfindlichkeit E_{A} allmählich in Abhängigkeit des Körperwiderstandes R_{K} angepasst wird.

Auf diese Weise können Fehlauslösungen der Sicherheitsvorrichtung 1 aufgrund eines schlechten oder nicht vorhandenen Kontakts zwischen Hautelektroden 3 und der Haut zumindest reduziert werden.

Eine mögliche Implementierung der Sicherheitsvorrichtung 1 ohne Bekleidungsstück 2 ist in Fig.5 dargestellt. Eine Person 8 trägt zumindest zwei Hautelektroden 3, die über Signalleitungen 4 mit einer Auswerteeinheit 6 verbunden sind. In der Auswerteeinheit 6 ist eine Energiequelle 12 vorgesehen, um über die Hautelektroden 3 ein Einspeisesignal S_{E}(f_{M}) bei einer vorgesehenen Einspeisefrequenz f_{M} einzuspeisen. Die Messeinheit 13 erfasst frequenzselektiv ein erstes Messsignal S_{K}(f_{K}) in einem vorgegebenen Messfrequenzbereich f_{K} und ein zweites Messsignal S_{M}(f_{M}) bei der Einspeisefrequenz f_{M} ungleich des Messfrequenzbereichs f_{K}. Das erste Messsignal S_{K} wird in einer Messsignalauswerteeinheit 16 ausgewertet und ein Auswertesignal S_{A} ermittelt, anhand dem auf einen unzulässigen Körperstrom i_{K} geschlossen wird, wenn eine vorgegebene Auslöseempfindlichkeit E_{A} erreicht wird. Mit dem zweiten Messsignal S_{M} und dem Einspeisesignal S_{E} wird der Körperwiderstand R_{K} ermittelt, beispielsweise in einer Widerstandauswerteeinheit 17, und die Auslöseempfindlichkeit E_{A} wird in Abhängigkeit vom ermittelten Körperwiderstand R_{K} vorgegeben. Die Widerstandauswerteeinheit 17 und Messsignalauswerteeinheit 16 sind in diesem Ausführungsbeispiel beide in einer Einheit integriert, beispielsweise als Software auf einer geeigneten mikroprozessorbasierten Recheneinheit.

## Patentansprüche

1. Sicherheitsvorrichtung mit zumindest zwei Hautelektroden (3), in der eine erste Messeinrichtung (14) und eine Messsignalauswerteeinheit (16) vorgesehen sind, wobei die erste Messeinrichtung (14) ein erstes elektrisches Messsignal (S_{K}(f_{K})) in einem Messfrequenzbereich (f_{K}) zwischen den zumindest zwei Hautelektroden (3) erfasst und die Messsignalauswerteeinheit (16) aus dem erfassten ersten Messsignal (S_{K}(f_{K})) ein Auswertesignal (S_{A}) ermittelt und die Sicherheitsvorrichtung (1) auslöst, wenn das Auswertesignal (S_{A}) eine vorgegebene Auslöseempfindlichkeit (E_{A}) der Sicherheitsvorrichtung (1) erreicht, und eine elektrische Energiequelle (12) vorgesehen ist, die über die zumindest zwei Hautelektroden (3) ein elektrisches Einspeisesignal (S_{E}(f_{M})) mit einer vorgegebenen Einspeisefrequenz (f_{M}) ungleich dem Messfrequenzbereich (f_{K}) eingespeist, wobei eine zweite Messeinrichtung (13) und eine Widerstandauswerteeinheit (17) vorgesehen sind und die zweite Messeinrichtung (13) ein zweites elektrisches Messsignal (S_{M}(f_{M})) bei der Einspeisefrequenz (f_{M}) erfasst und die Widerstandauswerteeinheit (17) aus dem erfassten zweiten Messsignal (S_{M}(f_{M})) und dem Einspeisesignal (S_{E}(f_{M})) einen zwischen den zumindest zwei Hautelektroden (3) auftretenden Körperwiderstand (R_{K}) ermittelt, **dadurch gekennzeichnet, dass** die Sicherheitsvorrichtung (1) die Auslöseempfindlichkeit (E_{A}) in Abhängigkeit vom ermittelten Körperwiderstand (R_{K}) verändert.

2. Sicherheitsvorrichtung nach Anspruch 1, **dadurch gekennzeichnet, dass** die Sicherheitsvorrichtung (1) ein akustisches, visuelles und/oder palpables Warnsignal (W) ausgibt, wenn der ermittelte Körperwiderstand (R_{K}) einen vorgegebenen Grenzwiderstand (R_{G}) überschreitet und/oder wenn die Sicherheitsvorrichtung (1) einen gefährlichen über den Körperwiderstand (R_{K}) fließenden Körperstrom (i_{K}) detektiert.

3. Sicherheitsvorrichtung nach Anspruch 1, **dadurch gekennzeichnet, dass** die Sicherheitsvorrichtung (1) ein Notsignal (S) ausgibt, wenn die Sicherheitsvorrichtung (1) einen gefährlichen über den Körperwiderstand (R_{K}) fließenden Körperstrom (i_{K}) detektiert.

4. Verfahren zum Betreiben einer Sicherheitsvorrichtung (1) mit zumindest zwei Hautelektroden (3), wobei ein erstes elektrisches Messsignal (S_{K}(f_{K})) in einem Messfrequenzbereich (f_{K}) zwischen den zumindest zwei Hautelektroden (3) erfasst wird und aus dem erfassten ersten Messsignal (S_{K}(f_{K})) ein Auswertesignal (S_{A}) ermittelt wird und die Sicherheitsvorrichtung (1) auslöst, wenn mit dem Auswertesignal (S_{A}) eine vorgegebene Auslöseempfindlichkeit (E_{A}) der Sicherheitsvorrichtung (1) erreicht wird, und wobei über die zumindest zwei Hautelektroden (3) ein elektrisches Einspeisesignal (S_{E}(f_{M})) mit einer vorgegebenen Einspeisefrequenz (f_{M}) ungleich dem Messfrequenzbereich (f_{K}) eingespeist wird und ein zweites elektrisches Messsignal (S_{M}(f_{M})) bei dieser Einspeisefrequenz (f_{M}) erfasst wird und aus dem erfassten zweiten Messsignal (S_{M}(f_{M})) und dem Einspeisesignal (S_{E}(f_{M})) ein zwischen den zumindest zwei Hautelektroden (3) auftretender Körperwiderstand (R_{K}) ermittelt wird, **dadurch gekennzeichnet, dass** die Auslöseempfindlichkeit (E_{A}) der Sicherheitsvorrichtung (1) in Abhängigkeit vom ermittelten Körperwiderstand (R_{K}) verändert wird.

5. Verfahren nach Anspruch 4, **dadurch gekennzeichnet, dass** ein akustisches, visuelles und/oder palpables Warnsignal (W) ausgegeben wird, wenn der ermittelte Körperwiderstand (R_{K}) einen vorgegebenen Grenzwiderstand (R_{G}) überschreitet und/oder wenn ein gefährlicher über den Körperwiderstand (R_{K}) fließender Körperstrom (i_{K}) detektiert wird.

6. Verfahren nach Anspruch 5, **dadurch gekennzeichnet, dass** von der Sicherheitsvorrichtung (1) ein Notsignal (S) ausgegeben wird, wenn von der Sicherheitsvorrichtung (1) ein gefährlicher über den Körperwiderstand (R_{K}) fließender Körperstrom (i_{K}) detektiert wird.

## Claims

1. A safety device with at least two skin electrodes (3), in which a first measuring device (14) and a measurement signal evaluation unit (16) are provided, wherein the first measuring device (14) detects a first electrical measurement signal (S_{K}(f_{K})) in a measurement frequency range (f_{K}) between the at least two skin electrodes (3) and the measurement signal evaluation unit (16) determines an evaluation signal (S_{A}) from the detected first measurement signal (S_{K}(f_{K})) and triggers the safety device (1) if the evaluation signal (S_{A}) reaches a specified triggering sensitivity (E_{A}) of the safety device (1), and an electrical energy source (12) is provided that feeds an electrical feed signal (S_{E}(f_{M})) having a specified feed frequency (f_{M}) unequal to the measurement frequency range (f_{K}) via the at least two skin electrodes (3), wherein a second measuring device (13) and a resistance evaluation unit (17) are provided, and the second measuring device (13) detects a second electrical measurement signal (S_{M}(f_{M})) at the feed frequency (f_{M}), and the resistance evaluation unit (17) determines a body resistance (R_{K}) occurring between the at least two skin electrodes (3) from the detected second measurement signal (S_{M}(f_{M})) and the feed signal (S_{E}(f_{M})), **characterized in that** the safety device (1) changes the triggering sensitivity (E_{A}) depending on the determined body resistance (R_{K}).

2. The safety device according to claim 1, **characterized in that** the safety device (1) emits an acoustic, visual or palpable warning signal (W) if the determined body resistance (R_{K}) exceeds a specified limit resistance (R_{G}) and/or if the safety device (1) detects a dangerous body current (i_{K}) flowing through the body resistance (R_{K}).

3. The safety device according to claim 1, **characterized in that** the safety device (1) emits an emergency signal (S) if the safety device (1) detects a dangerous body current (i_{K}) flowing through the body resistance (R_{K}).

4. A method for operating a safety device (1) comprising at least two skin electrodes (3), wherein a first electrical measurement signal (S_{K}(f_{K})) is detected in a measurement frequency range (f_{K}) between the at least two skin electrodes (3) and an evaluation signal (S_{A}) is determined from the detected first measurement signal (S_{K}(f_{K})) and the safety device (1) is triggered if the evaluation signal (S_{A}) reaches a specified triggering sensitivity (E_{A}) of the safety device (1), and wherein an electrical feed signal (S_{E}(f_{M})) having a specified feed frequency (f_{M}) unequal to the measurement frequency range (f_{K}) is fed via the at least two skin electrodes (3), and a second electrical measurement signal (S_{M}(f_{M})) is detected at this feed frequency (f_{M}), and a body resistance (R_{K}) occurring between the at least two skin electrodes (3) is determined from the detected second measurement signal (S_{M}(f_{M})) and the feed signal (S_{E}(f_{M})), **characterized in that** the triggering sensitivity (E_{A}) of the safety device (1) is changed depending on the determined body resistance (R_{K}).

5. The method according to claim 4, **characterized in that** an acoustic, visual and/or palpable warning signal (W) is output if the determined body resistance (R_{K}) exceeds a specified limit resistance (R_{G}) and/or a dangerous body current (i_{K}) flowing through the body resistance (R_{K}) is detected.

6. The method according to claim 5, **characterized in that** an emergency signal (S) is output by the safety device (1) if a dangerous body current (i_{K}) flowing through the body resistance (R_{K}) is detected by the safety device (1).

## Revendications

1. Dispositif de sécurité comportant au moins deux électrodes cutanées (3) dans lesquelles sont prévus un premier appareil de mesure (14) et une unité d'évaluation de signal de mesure (16), dans lequel le premier appareil de mesure (14) détecte un premier signal de mesure (S_{K}(f_{K})) électrique dans une plage de fréquences de mesure (f_{K}) entre les au moins deux électrodes cutanées (3) et l'unité d'évaluation de signal de mesure (16) détermine un signal d'évaluation (S_{A}) à partir du premier signal de mesure (S_{K}(f_{K})) détecté et déclenche le dispositif de sécurité (1) lorsque le signal d'évaluation (S_{A}) atteint une sensibilité de déclenchement (E_{A}) prédéfinie du dispositif de sécurité (1), et une source d'énergie électrique (12) est prévue, laquelle injecte un signal d'injection (S_{E}(f_{M})) électrique comportant une fréquence d'injection (f_{M}) prédéfinie différente de la plage de fréquences de mesure (f_{K}) par l'intermédiaire des au moins deux électrodes cutanées (3), dans lequel un second appareil de mesure (13) et une unité d'évaluation de résistance (17) sont prévus et le second appareil de mesure (13) détecte un second signal de mesure (S_{M}(f_{M})) électrique à la fréquence d'injection (f_{M}) et l'unité d'évaluation de résistance (17) détermine une résistance de corps (R_{K}) survenant entre les au moins deux électrodes cutanées (3) à partir du second signal de mesure (S_{M}(f_{M})) détecté et du signal d'injection (S_{E}(f_{M})), **caractérisé en ce que** le dispositif de sécurité (1) modifie la sensibilité de déclenchement (E_{A}) en fonction de la résistance de corps (R_{K}) déterminée.

2. Dispositif de sécurité selon la revendication 1, **caractérisé en ce que** le dispositif de sécurité (1) émet un signal d'avertissement (W) acoustique, visuel et/ou palpable lorsque la résistance de corps (R_{K}) déterminée dépasse une résistance limite (R_{G}) prédéfinie et/ou lorsque le dispositif de sécurité (1) détecte un courant de corps (i_{K}) dangereux circulant à travers la résistance de corps (R_{K}).

3. Dispositif de sécurité selon la revendication 1, **caractérisé en ce que** le dispositif de sécurité (1) émet un signal de détresse (S) lorsque le dispositif de sécurité (1) détecte un courant de corps (i_{K}) dangereux circulant à travers la résistance de corps (R_{K}).

4. Procédé permettant de faire fonctionner un dispositif de sécurité (1) comportant au moins deux électrodes cutanées (3), dans lequel un premier signal de mesure (S_{K}(f_{K})) électrique est détecté dans une plage de fréquences de mesure (f_{K}) entre les au moins deux électrodes cutanées (3) et, à partir du premier signal de mesure (S_{K}(f_{K})) détecté, un signal d'évaluation (S_{A}) est déterminé et déclenche le dispositif de sécurité (1) lorsqu'avec le signal d'évaluation (S_{A}), une sensibilité de déclenchement (E_{A}) prédéfinie du dispositif de sécurité (1) est atteinte, et dans lequel un signal d'injection (S_{E}(f_{M})) électrique comportant une fréquence d'injection (f_{M}) prédéfinie différente de la plage de fréquences de mesure (f_{K}) est injecté par l'intermédiaire des au moins deux électrodes cutanées (3) et un second signal de mesure (S_{M}(f_{M})) électrique est détecté à ladite fréquence d'injection (f_{M}) et, à partir du second signal de mesure (S_{M}(f_{M})) détecté et du signal d'injection (S_{E}(f_{M})), une résistance de corps (R_{K}) survenant entre les au moins deux électrodes cutanées (3) est déterminée, **caractérisé en ce que** la sensibilité de déclenchement (E_{A}) du dispositif de sécurité (1) est modifiée en fonction de la résistance de corps (R_{K}) déterminée.

5. Procédé selon la revendication 4, **caractérisé en ce qu'**un signal d'avertissement (W) acoustique, visuel et/ou palpable est émis lorsque la résistance de corps (R_{K}) déterminée dépasse une résistance limite (R_{G}) prédéfinie et/ou lorsqu'un courant de corps (i_{K}) dangereux circulant à travers la résistance de corps (R_{K}) est détecté.

6. Procédé selon la revendication 5, **caractérisé en ce qu'**un signal de détresse (S) est émis par le dispositif de sécurité (1) lorsqu'un courant de corps (i_{K}) dangereux circulant à travers la résistance de corps (R_{K}) est détecté par le dispositif de sécurité (1).
